# EUROPEAN PATENT APPLICATION

(11) **EP 1 729 349 A1**
(43) Veröffentlichungstag der Anmeldung: **06.12.2006**
(21) Anmeldenummer: 05731787.7
(22) Anmeldetag: 04.03.2005
(51) Int. Cl.: H01L 33/00

(54) **HOCHLEISTUNGS-LEUCHTDIODE**

(30) Priorität: 15.03.2004 RU 2004108063
(71) Anmelder: Zakrytoe Aksionernoe Obschestvo "Innovatsionnaya Firma "Tetis", St. Petersburg, 194156 (RU)
(72) Erfinder: ZAKGEIM, Dmitry Aleksandrovich, St. Petersburg, 197371 (RU); ZAKGEIM, Aleksandr Lvovich, St. Petersburg, 197371 (RU); GUREVICH, Sergei Aleksandrovich, St. Petersburg, 195227 (RU); SMIRNOVA, Irina Pavlovna, St. Petersburg, 197227 (RU); VASILIEVA, Elena Dmitrievna, St. Petersburg, 197371 (RU); ITKINSON, Grigory Vladimirovich, St. Petersburg, 197119 (RU)
(74) Vertreter: Jeck, Anton
(86) Internationale Anmeldenummer: PCT/RU2005/000110
(87) Internationale Veröffentlichungsnummer: WO 2005/088742

(57) **Zusammenfassung**

Es wird eine Leuchtdiode beschrieben, umfassend eine auf einem isolierenden Substrat (1) angeordnete Epitaxialstruktur mit einem p-n-Übergang, bei der eine metallische Kontaktfläche (7) zur n-Leitschicht Bereiche umfasst, die als abgesonderte Teilflächen ausgeführt sind, die in der Epitaxialstruktur bis zur n-Leitschicht abgeätzten Vertiefungen aufgesetzt sind, wobei die von den Teilflächen eingenommenen Bereiche in einem horizontalen Schnitt durch die Leuchtdiode allseitig von einem Gebiet umgeben sind, das von einer metallischen Kontaktfläche (6) zur p- Leitschicht belegt ist, wobei eine elektrische Kontaktierung der Teilflächen mittels oberhalb der Kontaktfläche (6) zu der p-Leitschicht verlaufend angeordneten Metallschienen (8) erfolgt.

## Beschreibung

Die Erfindung betrifft eine Leuchtdiode, insbesondere eine Leuchtdiode aus Nitrid-Verbindungen der Metalle der III Gruppe, insbesondere des Aluminiums, des Galliums und des Indiums (A^{III}N).

In den letzten Jahren finden Leuchtdioden immer breitere Anwendung in der Lichttechnik. Eine der Hauptanforderungen ist dabei eine hohe optische Ausgangsleistung.

Als viel versprechend gelten hierbei Leuchtdioden aus einer A1lnGaN Halbleiterverbindung, die epitaktisch auf einem isolierenden Substrat, beispielsweise auf Saphirsubstrat (Al₂O₃) gezüchtet sind, und die darüber hinaus einen mesaplanaren Aufbau aufweisen, bei dem metallische Kontaktflächen zu den n-und p-Leitschichten von der Seite der Epitaxialstruktur her angeordnet werden.

Eine wesentliche Bedingung für die Erhöhung der Ausgangsleistung einer Leuchtdiode ist, sie mit einem größtmöglichen Speisestrom versorgen zu können, und gleichzeitig sicherzustellen, dass der Speisestrom gleichmäßig über die Fläche des p-n-Übergangs verteilt wird.

Um die thermischen Verluste so klein wie möglich zu halten ist es weiterhin notwendig, dass die Leuchtdiode einen niedrigen elektrischen Widerstand aufweist, was für auf AllnGaN - Verbindungen bestehende Leuchtdioden eine schwierige Aufgabe ist. Letzteres ist dadurch bedingt, dass der Strom in den betrachtenden Leuchtdioden eine nicht unerhebliche Strecke durch eine 2-3 µm dünne n-GaN Leitschicht mit einer verhältnismäßig geringen elektrischen Leitfähigkeit zurücklegt. [X.Guo, E.Shubert Current crowding and optical saturation effects in GalnN/GaN LEDs grown on insulating substrates/Appl. Phys, Lett, v.78 (2001), p.3337].

Es sind Leuchtdioden mit einer Epitaxialstruktur aus AllnGaN Verbindungen mit kompliziert ausgeführten Kontaktflächen bekannt [vgl. US 6,307,218 B1], die eine Erhöhung des zulässigen Speisestroms und dessen gleichmäßige Verteilung sicherstellen sollen. So ist aus US 6,518,598 B1 eine Leuchtdiode bekannt, bei der für das Erreichen des erwähnten Ziels die auf dem Niveau der n- und p-Leitschichten angeordneten Kontaktflächen zu den n-und p- Leitschichten spiralförmig ausgebildet sind. Nachteilig an den bekannten Leuchtdioden ist, dass sie nur eine sehr beschränkte Erhöhung des Speisestroms zulassen und darüber hinaus eine sehr kompliziert herzustellende Topologie aufweisen, was einerseits deren Herstellung verteuert, und andererseits die Zuverlässigkeit solcher Leuchtdioden stark einschränkt.

Als Ausgangspunkt für die vorliegende Erfindung wurde eine aus US 6,521,914 bekannte Leuchtdiode gewählt.

Die genannte Leuchtdiode umfasst eine auf einem isolierenden Substrat angeordnete Epitaxialstruktur mit p-n-Übergang, welche n-und p- Leitschichten aus Nitrid-Metall-Verbindungen der dritten Gruppe A1ₓlnyGa_{1-(x+y)}N, (0≤x≤1, 0≤y≤1) enthält. Die Leuchtdiode hat einen mesaplanaren Aufbau mit einem durch das Substrat hindurchführenden Ausstrahlöffnung. Die Leuchtdiode weist eine auf dem Niveau der unteren n-Epitaxialleitschicht angeordnete metallische Kontaktfläche zur n-Leitschicht, sowie eine auf dem Niveau der oberen p-Epitaxialleitschicht angeordnete metallische Kontaktfläche zur p- Leitschicht auf. In einem horizontalen Schnitt durch die Leuchtdiode sind die Bereiche, die von der metallischen Kontaktfläche zur n-Leitschicht belegt sind, und die Bereiche, die von der metallischen Kontaktfläche zur p-Leitschicht belegt sind, in abwechselnden Streifen angeordnet. Die ineinander greifenden, fingerförmigen Streifen und eine kammerartige Struktur bilden.

Die beschriebene Leuchtdiode erträgt einen relativ großen Speisestrom von bis zu 1A. Gleichzeitig weist diese Leuchtdiode einen verhältnismäßig niedrigen elektrischen Widerstand von etwa 1 Ohm auf. Dadurch wird eine hohe optische Ausgangsleistung bei hohem Wirkungsgrad erreicht. Beim gegebenen Aufbau der Leuchtdiode bildet jedoch die Summe der länglichen Streifen die Kontaktfläche zur n-Leitschicht, was zum Verlust eines erheblichen Teils der durch die Fläche des p-n - Übergangs gebildeten aktiven Fläche der Leuchtdiode führt. Dies wiederum begrenzt folglich die Möglichkeiten der Verbesserung der erwähnten Energieparameter der betrachteten Leuchtdiode.

Eine Aufgabe der Erfindung ist es deshalb, die optische Ausgangsleistung sowie den Wirkungsgrad einer Leuchtdiode zu verbessern.

Die Aufgabe wird durch eine Leuchtdiode gelöst, die eine auf einem isolierenden Substrat angeordnete Epitaxialstruktur mit einem p-n-Übergang umfasst. Die Epitaxialstruktur weist vorzugsweise n- und p- Leitschichten aus Nitrid-Metall-Verbindungen der dritten Gruppe A1ₓlnyGa_{1-(x+y)}N, (0≤x≤1, 0≤y≤1) auf. Die Leuchtdiode weist metallische Kontaktflächen zu den n-und p- Leitschichten auf, die von der Seite der Epitaxialschichten her entsprechend auf dem Niveau der unteren n-Epitaxialleitschicht und auf dem Niveau der oberen p-Epitaxialleitschicht angeordnet sind. In einem horizontalen Schnitt durch die Leuchtdiode sind die Bereiche, die von der metallischen Kontaktfläche zur n- Leitschicht eingenommen werden, und die Bereiche, die von der metallischen Kontaktfläche zur p-Leitschicht eingenommen werden, in abwechselnden Zonen angeordnet.

Erfindungsgemäß umfasst die metallische Kontaktfläche zur n-Leitschicht Bereiche, die als abgesonderte Teilflächen ausgeführt sind, die in der Epitaxialstruktur bis zu der n- Leitschicht abgeätzten Vertiefungen aufgesetzt sind. In einem horizontalen Schnitt durch die Leuchtdiode sind dabei die Bereiche, die von den erwähnten Teilflächen eingenommen werden, allseitig von einem Gebiet umgeben, das von der metallischen Kontaktfläche zur p- Leitschicht belegt ist. Die Teilflächen der metallischen Kontaktfläche zur n-Leitschicht sind mittels metallischer Schienen elektrisch miteinander verbunden. Die metallischen Schienen sind durch eine Schicht aus isolierendem Werkstoff getrennt über der metallischen Kontaktfläche zur p-Leitschicht verlaufend angeordnet. Der isolierende Werkstoff ist dabei vorzugsweise nur auf denjenigen Bereichen der Kontaktfläche zur p-Leitschicht aufgetragen, auf denen die metallischen Schienen verlaufen.

Eine vorteilhafte Ausgestaltung der Erfindung sieht vor, dass die Teilflächen der metallischen Kontaktfläche zur n -Leitschicht kreisförmig ausgebildet sind. Dabei sind die Teilflächen in einem horizontalen Schnitt durch die Leuchtdiode vorzugsweise gleichmäßig über die Fläche der Leuchtdiode verteilt und vorzugsweise in Reihen angeordnet.

Eine andere vorteilhafte Ausgestaltung der Erfindung sieht vor, dass die metallische Kontaktfläche zur p- Leitschicht die Form eines Quadrates aufweist, wobei die metallische Kontaktfläche zur n - Leitschicht vier Teilflächen umfasst. Dabei weist jede der Teilflächen die Form von zwei einen rechten Winkel einschließenden Schenkeln auf. Die Teilflächen sind auf solche Weise in der Epitaxialstruktur bis zu der n- Leitschicht abgeätzten Vertiefungen aufgesetzt, dass sie in einem horizontalen Schnitt durch die Leuchtdiode die Ecken eines Quadrats bilden.

Dadurch, dass die metallische Kontaktfläche zur n-Leitschicht die Zonen umfasst, die als abgesonderte Teilflächen ausgeführt sind, welche derart in der Epitaxialstruktur bis zu der n- Leitschicht abgeätzten Vertiefungen aufgesetzt sind, dass in einem horizontalen Schnitt durch die Leuchtdiode diejenigen Gebiete, die von den genannten Teilflächen eingenommen werden, sich mit Gebieten abwechseln, die von der metallischen Kontaktfläche zur p-Leitschicht eingenommen werden und darüber hinaus von letzteren allseitig umgeben sind, wird selbst bei Leuchtdioden mit großen Abmessungen eine gleichmäßige Einleitung des elektrischen Stroms in das Gebiet des p-n Übergangs erreicht. Dementsprechend wird eine annähernd gleichmäßige Verteilung des Stroms über die Fläche des p-n Übergangs sichergestellt. Durch Verwendung metallischer, durch lokal angeordneten, isolierenden Werkstoff von der metallischen Kontaktfläche zur p-Leiterschicht getrennte Schienen zur elektrischen Verbindung der abgesonderten Teilflächen wird ein erheblicher Teil des aktiven Gebiets der Leuchtdiode freigehalten. Darüber hinaus wird der im Wesentlichen durch den Stromfluss über die metallischen Kontakte zum n-Gebiet bestimmte elektrische Widerstand verringert. Die Gesamtheit der erwähnten Faktoren stellt eine Erhöhung der optischen Ausgangsleistung bei gleich bleibender Fläche der vorgeschlagenen Leuchtdiode gegenüber einer herkömmlichen Leuchtdiode sicher.

Ausführungsbeispiele der vorliegenden Erfindung werden nachfolgend anhand der beigefügten Zeichnungen erklärt. Dabei zeigen:
- Fig. 1: eine schematische Darstellung einer Leuchtdiode mit kreisrund ausgeführten Teilflächen als metallische Kontaktflächen zur n-Leitschicht in der Draufsicht.
- Fig.2: Die Schnitte A-A (links) und B-B (rechts) aus Fig. 1.
- Fig. 3: eine schematische Darstellung einer alternativen Ausführungsform der erfindungsgemäßen Leuchtdiode mit als rechte Winkel ausgebildeten Teilflächen der metallischen Kontaktfläche zur n-Leitschicht in einer Draufsicht.

Eine erfindungsgemäße Leuchtdiode umfasst ein insbesondere einem Saphir hergestelltes Substrat 1, sowie eine auf dem Substrat 1 gewachsene Epitaxialstruktur aus einer Nitrid-Metall-Verbindung der dritten Gruppe A1ₓln_{y}Ga_{1-(x+y)}N, (0≤x≤1, 0≤y≤1). Die Epitaxialstruktur ist vorzugsweise durch metallorganische Dampfphasenepitaxie auf dem Substrat 1 gezüchtet. Selbstverständlich ist hierbei auch jedes andere Epitaxieverfahren denkbar.

Die Epitaxialstruktur umfasst eine dem Substrat 1 am nächsten liegende vorzugsweise als n-GaN Schicht ausgeführte n- Stromleitschicht 2, eine den p-n Übergang einschließende, vorzugsweise als InₓGa₁₋ₓN Schicht ausgeführte aktive Schicht 3, eine vorzugsweise als p-A1ₓGa₁₋ₓN Schicht ausgeführte Sperrschicht 4, sowie eine vorzugsweise als p-GaN Schicht ausgeführte p-Leitschicht 5. Die Leuchtdiode umfasst darüber hinaus eine metallische Kontaktfläche 6 zur p- Leitschicht 5 und eine metallische Kontaktfläche 7 zur n-Leitschicht 2.

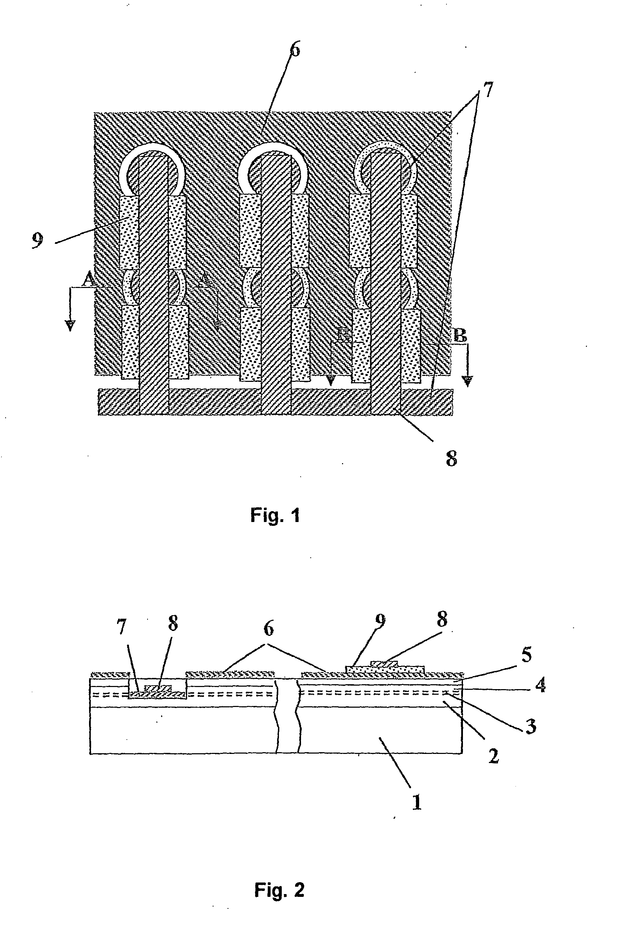

Bei der in den Fig.1 und 2 dargestellten Leuchtdiode weist die Kontaktfläche 6 in einem horizontalen Schnitt durch die Leuchtdiode eine rechteckige Form auf und nimmt fast die ganze Fläche der Leuchtdiode ein. Die Kontaktfläche 7 wird von einem Streifen gebildet, der entlang einer Seite der Kontaktfläche 6 in einer bis zum Niveau der n-Leitschicht 2 geätzten Vertiefung verläuft, sowie durch kreisrund ausgeführte Teilflächen, die ebenfalls in bis zum Niveau der n-Leitschicht 2 geätzten Vertiefungen angeordnet sind. Die die Teilflächen aufnehmenden, in die Epitaxialstruktur bis zum Niveau der n-Leitschicht 2 geätzten Vertiefungen weisen ebenfalls eine kreisrunde Form auf.

Die erwähnten Teilflächen sind in einem horizontalen Schnitt durch die Leuchtdiode gleichmäßig über die Fläche der Leuchtdiode verteilt in Reihen angeordnet. Sie sind mit dem streifenförmigen Bereich der Kontaktfläche 7 elektrisch verbunden. Diese elektrische Verbindung ist mittels metallischer Schienen 8 hergestellt. Auf diejenigen Bereiche der Kontaktfläche 6, auf denen die metallischen Schienen 8 verlaufen, sind jeweils Streifen einer Schicht 9 aus einem isolierenden Werkstoff, beispielsweise aus Magnetron-SiO₂, aufgetragen.

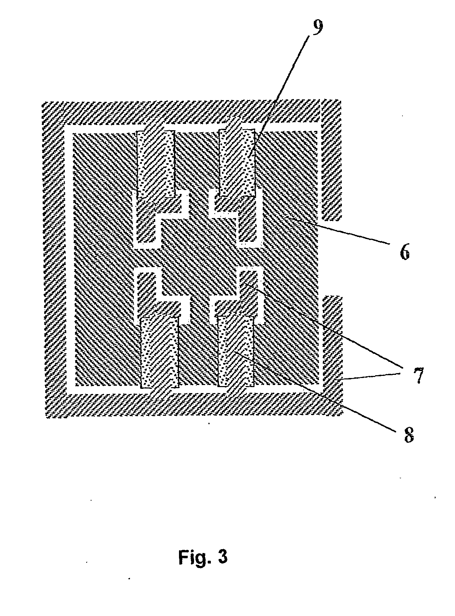

Bei der in Fig. 3 dargestellten Leuchtdiode weist die Kontaktfläche 6 in einem horizontalen Schnitt durch die Leuchtdiode die Form eines Quadrates auf und nimmt fast die ganze Fläche der Leuchtdiode ein. Die Kontaktfläche 7 wird bei dieser Ausführungsform von einem Streifen gebildet, der über den Umfang der Kontaktfläche 6 in einer eine korrespondierende Form aufweisenden Vertiefung angeordnet ist, die in die Epitaxialstruktur bis zu dem Niveau der n-Leitschicht 2 geätzt ist, sowie von vier Teilflächen, von denen jede die Form zweier einen rechten Winkel einschließenden Schenkel aufweist und die ebenfalls in bis zum Niveau der n-Leitschicht 2 geätzten Vertiefungen angeordnet sind.

Die erwähnten Teilflächen sind auf solche Weise angeordnet, dass sie in einem horizontalen Schnitt durch die Leuchtdiode, innerhalb eines zentralen Teils der Querschnittsfläche der Leuchtdiode die Ecken eines Quadrates bilden. Die Teilflächen sind mittels metallischer Schienen 8 mit dem als Streifen ausgeführten Bereich der Kontaktfläche 7 elektrisch verbunden. Über denjenigen Bereichen der Kontaktfläche 6, auf denen die metallischen Schienen 8 angeordnet sind, ist eine Schicht aus einem isolierenden Werkstoff angeordnet.

### Die erfindungsgemäße Leuchtdiode arbeitet auf folgende Weise:

Bei Stromzufuhr zur Leuchtdiode fließt der Strom von der Kontaktfläche 6 durch die Schichten 5, 4, 3 und über die Schicht 2 der Epitaxialstruktur zur Kontaktfläche 7. In der aktiven Schicht 3, wo der p-n-Übergang angeordnet ist, wird bei Stromfluss eine Lichtemission erzeugt.

Da die p - Leitschicht und die Sperrschicht 4 eine wesentlich niedrige Leitfähigkeit als die n - Stromleitschicht 2 haben, fließt der Strom nicht über die Schichten 5 und 4, sondern senkrecht nach unten bis zur den p-n-Übergang umfassenden aktiven Schicht 3. Dabei entspricht das Gebiet, in der die Erzeugung der Lichtemission stattfindet, geometrisch demjenigen Gebiet, das von der Kontaktfläche 6 zur p-Leitschicht 5 eingenommen ist. Da in der betrachtenden Leuchtdiode die Fläche, die von den Teilflächen der Kontaktfläche 7 belegt ist, wesentlich kleiner ist, als die von der Kontaktfläche 6 belegte Fläche, weist die erfindungsgemäße Leuchtdiode gegenüber dem Stand der Technik eine wesentlich größere Fläche des für die Erzeugung der Lichtemission zuständigen aktiven Gebiets auf. Dies wird erfindungsgemäß unter anderem auch dadurch erreicht, dass für die elektrische Kontaktierung der Teilflächen metallischen Schienen 8 verwendet werden, die oberhalb der Kontaktfläche 6 zur p-Leitschicht 5 verlaufend angeordnet sind. Dadurch ist der Anteil der von der Kontaktfläche 6 belegten Gesamtfläche der Leuchtdiode bei der erfindungsgemäßen Leuchtdiode wesentlich größer, als beim Stand der Technik. Darüber hinaus kann dadurch der Querschnitt der metallischen Schienen 8 genügend groß dimensioniert werden, wodurch der elektrische Widerstand der Kontaktierung des n-Gebiets gegenüber dem Stand der Technik verringert werden kann. Beim Stand der Technik ist der Querschnitt der elektrischen Kontaktierung des n-Gebiets durch die notwendigerweise zur Erzeugung einer Lichtemission erforderliche verbleibende Fläche des aktiven Gebiets beschränkt. Durch freie Wahl der Form und/oder der Anzahl der Teilflächen, der Kontaktfläche 7 zur n-Leitschicht 2, und auch des Schemas deren Verteilung über die Fläche der Leuchtdiode kann bei der erfindungsgemäßen Leuchtdiode eine in höchstem Maße gleichmäßige Verteilung des Stroms über den p-n-Übergang erreicht werden. Dies erlaubt einen gegenüber dem Stand der Technik deutlich höheren Speisestrom, wodurch wiederum eine wesentlich höhere optische Ausgangsleistung, sowie ein wesentlich höherer Wirkungsgrad erreicht wird.

Die vorliegende Erfindung kann eine breite Anwendung in verschiedenen Bereichen der Wirtschaft finden. Die erfindungsgemäße Leuchtdiode kann als Leuchtquelle in vielen lichtoptischen Einrichtungen, zum Beispiel in mit Leuchtdioden ausgestatteten Eisenbahnsignalen, in Ampelanlagen, als Beleuchtungseinrichtungen für Werbeschilder und für Verkehrsschilder verwendet werden. Besonders viel versprechend ist die Nutzung der vorliegenden Erfindung in Lichteinrichtungen, die für Straßenbeleuchtung und zur Beleuchtung von Räumen vorgesehen sind.
Die erfindungsgemäße Leuchtdiode wurde im Forschungslaboratorium für optische Messungen von ZAO " Swetlana-Optoelektronik " getestet, wo sie eine hohe optische Effektivität gezeigt hat. So konnten für eine Leuchtdiode mit einem in Fig. 3 dargestellten Aufbau die nachfolgenden Eigenschaften nachgewiesen werden: bei einer aktiven Fläche von 1 mm² betrug der Wert des direkten Stroms 2A, und der Wert des elektrischen Widerstands 0,7 Ohm , was die hohe optische Ausgangsleistung und den hohen Wirkungsgrad der vorliegenden Leuchtdiode aufzeigt. Außerdem verfügt die erfindungsgemäße Leuchtdiode über eine hohe Temperaturstabile und über lange Zeit konstante Parameter.

## Patentansprüche

1. Leuchtdiode, umfassend eine auf einem isolierenden Substrat (1) angeordnete Epitaxialstruktur mit einem p-n-Übergang, **dadurch gekennzeichnet, dass** eine metallische Kontaktfläche (7) zur n-Leitschicht Bereiche umfasst, die als abgesonderte Teilflächen ausgeführt sind, die in der Epitaxialstruktur bis zur n- Leitschicht abgeätzten Vertiefungen aufgesetzt sind, wobei die von den Teilflächen eingenommenen Bereiche in einem horizontalen Schnitt durch die Leuchtdiode allseitig von einem Gebiet umgeben sind, das von einer metallischen Kontaktfläche (6) zur p- Leitschicht belegt ist, wobei eine elektrische Kontaktierung der Teilflächen mittels oberhalb der Kontaktfläche (6) zu der p-Leitschicht verlaufend angeordneten Metallschienen (8) erfolgt.

2. Leuchtdiode nach Anspruch 1, **dadurch gekennzeichnet, dass** die Epitaxialstruktur n-und p- Leitschichten (2, 5) aus Nitrid-Metall-Verbindungen der dritten Gruppe A1ₓln_{y}Ga_{1-(x+y)}N, (0≤x≤1, (0≤y≤1) umfasst.

3. Leuchtdiode nach Anspruch 1 oder 2, **dadurch gekennzeichnet, dass** die Leuchtdiode metallische Kontaktflächen (6, 7) zu den n-und p- Leitschichten aufweist, die von der Seite der Epitaxialschichten her entsprechend auf dem Niveau der unteren n-Epitaxialleitschicht und auf dem Niveau der oberen p-Epitaxialleitschicht angeordnet sind.

4. Leuchtdiode nach Anspruch 1, 2 oder 3, **dadurch gekennzeichnet, dass** in einem horizontalen Schnitt durch die Leuchtdiode die Bereiche, die von der metallischen Kontaktfläche (7) zur n- Leitschicht eingenommen werden, und die Bereiche, die von der metallischen Kontaktfläche (6) zur p-Leitschicht eingenommen werden, in abwechselnden Zonen angeordnet sind.

5. Leuchtdiode nach einem der Ansprüche 1 bis 4, **dadurch gekennzeichnet, dass** die metallischen Schienen (8) durch eine Schicht aus isolierendem Werkstoff getrennt über der metallischen Kontaktfläche (6) zur p-Leitschicht verlaufend angeordnet sind.

6. Leuchtdiode nach Anspruch 5, **dadurch gekennzeichnet, dass** der isolierende Werkstoff nur auf denjenigen Bereichen der Kontaktfläche (6) zur p-Leitschicht aufgetragen ist, auf denen die metallischen Schienen (8) verlaufen.

7. Leuchtdiode nach einem der vorhergehenden Ansprüche, **dadurch gekennzeichnet, dass** die Teilflächen der metallischen Kontaktfläche (7) zur n -Leitschicht kreisförmig ausgebildet sind.

8. Leuchtdiode nach Anspruch 7, **dadurch gekennzeichnet, dass** die Teilflächen in einem horizontalen Schnitt durch die Leuchtdiode gleichmäßig über die Fläche der Leuchtdiode verteilt und in Reihen angeordnet sind.

9. Leuchtdiode nach einem der vorhergehenden Ansprüche, **dadurch gekennzeichnet, dass** die metallische Kontaktfläche (6) zur p- Leitschicht die Form eines Quadrates aufweist, wobei die metallische Kontaktfläche (7) zur n - Leitschicht vier Teilflächen umfasst.

10. Leuchtdiode nach Anspruch 9, **dadurch gekennzeichnet, dass** jede der Teilflächen die Form von zwei einen rechten Winkel einschließenden Schenkeln aufweist.

11. Leuchtdiode nach Anspruch 7 oder 8, **dadurch gekennzeichnet, dass** die Teilflächen auf solche Weise in der Epitaxialstruktur bis zu der n- Leitschicht abgeätzten Vertiefungen aufgesetzt sind, dass sie in einem horizontalen Schnitt durch die Leuchtdiode die Ecken eines Quadrats bilden.

12. Leuchtdiode, umfassend eine auf einem isolierenden Substrat (1) angeordnete Epitaxialstruktur mit einem p-n-Übergang, welche n-und p-Leitschichten (2, 5) aus Nitrid-Metall-Verbindungen der dritten Gruppe A1ₓln_{y}Ga_{1-(x-y)}N, (0≤x≤1, 0≤y≤1) enthält, sowie metallische Kontaktflächen (7, 6) zu den n-und p- Leitschichten (2, 5) aufweist, die von der Seite der Epitaxialschichten her entsprechend auf dem Niveau der unteren n-Epitaxialleitschicht (2) und auf dem Niveau der oberen p-Epitaxialleitschicht (5) angeordnet sind, wobei in einem horizontalen Schnitt durch die Leuchtdiode die Bereiche, die von der metallischen Kontaktfläche (7) zur n-Leitschicht (2) eingenommen werden, und die Bereiche, die von der metallischen Kontaktfläche (6) zur p-Leitschicht (5) eingenommen werden, in abwechselnden Zonen angeordnet sind, **dadurch gekennzeichnet, dass** die metallische Kontaktfläche (7) zur n-Leitschicht (2) Bereiche umfasst, die als abgesonderte Teilflächen ausgeführt sind, welche in der Epitaxialstruktur bis zu der n- Leitschicht (2) abgeätzten Vertiefungen aufgesetzt sind, wobei in einem horizontalen Schnitt durch die Leuchtdiode diejenigen Bereiche, die von den erwähnten Teilflächen eingenommen werden, allseitig von einem Gebiet umgeben sind, das von der metallischen Kontaktfläche (6) zur p- Leitschicht (5) belegt ist, und wobei die Teilflächen der metallischen Kontaktfläche (7) zur n-Leitschicht (2) mittels metallischer Schienen (8) elektrisch miteinander verbunden sind, welche oberhalb der metallischen Kontaktfläche (6) zur p-Leitschicht (5) verlaufend angeordnet, und durch eine auf die von den metallischen Schienen (8) abgedeckten Bereichen der Kontaktfläche (6) aufgetragene Schicht (9) aus einem isolierenden Werkstoff von der Kontaktfläche (6) isoliert sind.

13. Leuchtdiode nach Anspruch 12, **dadurch gekennzeichnet, dass** die Teilflächen der metallischen Kontaktfläche (7) zur n -Leitschicht (2) kreisförmig ausgebildet sind, und die Teilflächen in einem horizontalen Schnitt durch die Leuchtdiode gleichmäßig über die Fläche der Leuchtdiode verteilt in Reihen angeordnet sind.

14. Leuchtdiode nach Anspruch 12, **dadurch gekennzeichnet, dass** die metallische Kontaktfläche (6) zur p-Leitschicht (5) die Form eines Quadrates aufweist und die metallische Kontaktfläche (7) zur n-Leitschicht (2) vier Teilflächen umfasst, von denen jede die Form von zwei einen rechten Winkel einschließenden Schenkeln aufweist, wobei die Teilflächen auf solche Weise in der Epitaxialstruktur bis zu der n- Leitschicht abgeätzten Vertiefungen aufgesetzt sind, dass sie in einem horizontalen Schnitt durch die Leuchtdiode und innerhalb eines zentralen Teils der Querschnittsfläche der Leuchtdiode die Ecken eines Quadrats bilden.
